# EUROPEAN PATENT SPECIFICATION

(11) **EP 2 395 133 B1**
(45) Date of publication and mention of the grant of the patent: **04.03.2020**
(21) Application number: 10735972.1
(22) Date of filing: 29.01.2010
(51) Int. Cl.: C30B 29/36, C23C 16/42, C30B 25/20, H01L 21/205, C23C 16/32, C30B 25/18

(54) **METHOD FOR PRODUCING EPITAXIAL SILICON CARBIDE SINGLE CRYSTAL SUBSTRATE**
HERSTELLUNGSVERFAHREN FÜR EPITAKTISCHES SILIZIUMCARBID-EINKRISTALLSUBSTRAT
PROCÉDÉ DE FABRICATION D' UN SUBSTRAT MONOCRISTALLIN DE CARBURE DE SILICIUM ÉPITAXIAL

(30) Priority: 30.01.2009 JP 2009019323
(43) Date of publication of application: 14.12.2011
(73) Proprietor: Showa Denko K.K., Tokyo 105-8518 (JP)
(72) Inventor: AIGO, Takashi, Tokyo 100-8071 (JP); TSUGE, Hiroshi, Tokyo 100-8071 (JP); HOSHINO, Taizo, Tokyo 100-8071 (JP); FUJIMOTO, Tatsuo, Tokyo 100-8071 (JP); KATSUNO, Masakazu, Tokyo 100-8071 (JP); NAKABAYASHI, Masashi, Tokyo 100-8071 (JP); YASHIRO, Hirokatsu, Tokyo 100-8071 (JP)
(74) Representative: Vossius & Partner Patentanwälte Rechtsanwälte mbB
(86) International application number: PCT/JP2010/051655
(87) International publication number: WO 2010/087518

(56) References cited:
- EP-A1- 0 962 963
- JP-A- 2000 001 398
- JP-A- 2005 093 477
- JP-A- 2006 321 696
- JP-A- 2006 321 707
- JP-A- 2006 328 455
- JP-A- 2007 131 504
- CALCAGNO L ET AL: "Optical and electrical properties of 4H-SiC epitaxial layer grown with HCl addition", JOURNAL OF APPLIED PHYSICS, AMERICAN INSTITUTE OF PHYSICS, 2 HUNTINGTON QUADRANGLE, MELVILLE, NY 11747, vol. 102, no. 4, 29 August 2007 (2007-08-29), pages 43523-43523, XP012101508, ISSN: 0021-8979, DOI: 10.1063/1.2767248
- PEDERSEN H ET AL: "Donor incorporation in SiC epilayers grown at high growth rate with chloride-based CVD", JOURNAL OF CRYSTAL GROWTH, ELSEVIER, AMSTERDAM, NL, vol. 311, no. 5, 24 December 2008 (2008-12-24), pages 1321-1327, XP025967261, ISSN: 0022-0248, DOI: 10.1016/J.JCRYSGRO.2008.12.029 [retrieved on 2009-02-15]
- LA VIA F ET AL: "4H SIC EPITAXIAL GROWTH WITH CHLORINE ADDITION", CHEMICAL VAPOR DEPOSITION, WILEY-VCH VERLAG, WEINHEIM, DE, vol. 12, 1 January 2006 (2006-01-01), pages 509-515, XP001501955, ISSN: 0948-1907, DOI: 10.1002/CVDE.200506465
- ZHANG J ET AL: "High Quality Epitaxial Growth on 4[deg.] Off-axis 4H SiC with Addition of HCl", MATERIALS SCIENCE FORUM, TRANS TECH PUBLICATIONS LTD- SWITZERLAND, CH, vol. 600-603, 1 January 2009 (2009-01-01), pages 103-106, XP003032647, ISSN: 0255-5476
- LA VIA F ET AL: "SiC-4H Epitaxial Layer Growth by Trichlorosilane (TCS) as Silicon Precursor at Very High Growth Rate", MATERIALS SCIENCE FORUM, TRANS TECH PUBLICATIONS LTD- SWITZERLAND, CH, vol. 600-603, 1 January 2009 (2009-01-01), pages 123-126, XP003032648, ISSN: 0255-5476, DOI: 10.4028/WWW.SCIENTIFIC.NET/MSF.600-603.123
- HENRY A ET AL: "Growth of 4H-SiC epitaxial layers on 4[deg.] off-axis Si-face substrates", MATERIALS SCIENCE FORUM, TRANS TECH PUBLICATIONS LTD- SWITZERLAND, CH, vol. 615-617, 1 January 2009 (2009-01-01), pages 81-84, XP003032644, ISSN: 0255-5476

## Description

### Technical Field

**0001** The present invention relates to an epitaxial silicon carbide (SiC) monocrystalline substrate and a method of production of the same.

### Background Art

**0002** Silicon carbide (SiC) is superior in heat resistance and mechanical strength and is physically and chemically stable, so has been coming under attention as an environmentally resistant semiconductor material. Further, in recent years, demand for SiC monocrystalline substrates as substrates for high frequency, high withstand voltage devices has been rising.

**0003** When using an SiC monocrystalline substrate to produce a power device, high frequency device, etc., usually the general practice is to use the method called the "thermal CVD method" to epitaxially grow an SiC thin film on the substrate or to use the ion implantation method to directly drive in a dopant, but in the latter case, after the implantation, annealing at a high temperature becomes necessary, so much use is made of thin film formation using epitaxial growth.

**0004** In recent years, along with advances in SiC device technology, SiC epitaxial substrates have also been asked to offer higher quality and larger size. In the SiC substrates used for epitaxial growth, from the viewpoint of the stability and reproducibility of epitaxial growth, substrates with an "off angle" are being used. Usually, this is 8°. Such an SiC substrate is prepared by cutting it out from an SiC ingot with a surface of the (0001) plane while imparting a desired angle. The larger the off angle, the less the number of substrates which are obtained from a single ingot. Further, increasing the size and length of ingots becomes difficult. Therefore, to efficiently produce a large sized SiC substrate, it is essential to reduce the off angle. For the current SiC substrates having a 3 inch (75 mm) or greater size, substrates having a 6° or less off angle are the mainstream. Research is being conducted on epitaxial growth using such substrates.

**0005** However, the off angle becomes smaller and the number of steps present on the substrate decreases, so step flow growth becomes harder at the time of epitaxial growth and, as a result, steps gather together resulting in so-called "step bunching".

**0006** Therefore, as a method for suppressing the occurrence of step bunching, NPLT 1 reports a method of lowering the ratio of the numbers of atoms of carbon and silicon (C/Si ratio) contained in the material gases (source gases) at the time of epitaxial growth. Further, PLT 1 describes that by lowering the C/Si ratio at the start of growth to 0.5 to 1.0, it is possible to suppress the occurrence of spiral growth starting from spiral dislocations and to raise the probability of being covered by the large amount of step flows in the surroundings so as to reduce epitaxial defects.

**0007** However, if lowering the C/Si ratio, residual nitorogen is easily taken into the epitaxial film. This acts as a donor, so raising the purity of the film becomes difficult. Therefore, this is not suited for practical use.

**0008** Further, PLT 2 discloses to obtain an epitaxial thin film with a low crystal defect density and a good crystallinity at the time of epitaxial growth by growing an epitaxial layer in an atmosphere to which hydrogen chloride gas has been added. This means to simply reduce the crystal defect density and improve the crystallinity of an epitaxial thin film by the etching action of the added hydrogen chloride (cleaning of substrate surface). Specifically, an SiC substrate with an off angle of 8° is formed with a film by epitaxial growth under conditions of inclusion of gases of 3 to 30 ml/min of HCl and 0.3 ml/min of SiH₄ (if converted to the Cl/Si ratio, 10 to 100), that is, under conditions of increasing the ratio of hydrogen chloride to a Cl/Si ratio of 100 during growth so as to promote the etching action. Further, PLT 3 describes that in the case of use of the thermal CVD method for epitaxial growth, there is a problem of partial formation of cubic crystal (3C structure) SiC, discloses to solve said problem by simultaneously feeding HCl gas together with a silicon hydride gas, a hydrocarbon gas, and a carrier gas, and describes that it is possible to grow an SiC epitaxial layer using a slanted substrate slanted by a slant angle smaller than the past (with a smaller off angle).

**0009** Note that, while relating to an SiC substrate before epitaxial growth, using Cl₂ gas or HCl gas to etch the surface of an SiC substrate to smooth it is disclosed in PLT 4.

**0010** Further, PLT 5 discloses that in the case of the CVD method at a low temperature of about 1200°C, the problem arises of formation of silicon particles in the vapor phase and that to solve said problem, HCl gas may be added to thereby stabilize the reaction and prevent the formation of silicon particles in the vapor phase. Further, PLT 6 describes to promote the reaction of the source gases in the low temperature CVD method and to form an SiC crystal film even in a low temperature region of 900°C or less by mixing HCl gas in the source gases and that, further, since this is a low temperature CVD method, growth of a mirror surface is possible at a temperature of the substrate temperature of 1400°C or less. Furthermore, PLT 7 describes to smooth the surface of a silicon carbide monocrystalline film by adding HCl gas to the source gases thereby producing a film with a surface roughness of about 5 nm. This surface roughness is obtained by making the flow rate of the HCl gas 3 CCM (by Cl/Si ratio, 15) as against a flow rate of the silane (SiH₄) of 0.2 CCM in the CVD method with a substrate temperature of 1350°C.

In NPLT 2, Calcagno et al. reported on the optical and electrical properties of 4H-SiC epitaxial layer grown with HCl addition. Donor incorporation in SiC epilayers grown at high growth rate with chloride-based CVD has been described by Pedersen et al. in NPLT 3.

La Via et al. reported in NPLT 4 on the 4H SiC epitaxial growth with chlorine addition, and in NPLT 6 on the SiC-4H epitaxial layer growth by trichlorosilane as silicon precursor at very high growth rate.

NPLT 5 describes the epitaxial growth on 4° off-axis 4H SiC with addition of HCl. Furthermore, the growth of 4H-SiC epitaxial layers on 4° off-axis Si-face substrates has been reported by Henry et al. in NPLT 7.

PLT 8 discloses a method of producing a silicon carbide substrate, in which a silicon carbide crystal is grown by supplying silicon atoms and carbon atoms on a surface of a silicon carbide substrate, characterized in that said surface of said silicon carbide substrate on which said silicon carbide crystal is to be grown is an off-cut surface inclined 0.05° to 10° with respect to one of the faces selected from a {0001} face of a hexagonal silicon carbide crystal and a {111} face of a cubic silicon carbide crystal, and
an amount of silicon atoms to be supplied and an amount of carbon atoms to be supplied are so controlled that said amount of silicon atoms is in excess of said amount of carbon atoms on the surface of said silicon carbide substrate.

**0011** Therefore, in the future, application to devices is expected from SiC epitaxial growth substrate. Along with the increasingly larger size of substrates, substrates with small off angles will become used. If so, with current art, devices will be fabricated on epitaxial films with residual step bunching. The inventors engaged in detailed studies by fabricating devices on substrates with small off angles. As a result, the following became clear. On the surfaces of such epitaxial films, large numbers of relief shapes are formed as a result of which electric field concentration easily occurs under the device electrodes. In particular, if considering application to Schottky barrier diodes, MOS transistors, etc., this electric field concentration results in remarkable gate leak current and degrades the device characteristics.

### Citation List

### Patent Literature

**0012** PLT 1: Japanese Patent Publication (A) No. 2008-74664
PLT 2: Japanese Patent Publication (A) No. 2000-001398
PLT 3: Japanese Patent Publication (A) No. 2006-321696
PLT 4: Japanese Patent Publication (A) No. 2006-261563
PLT 5: Japanese Patent Publication (A) No. 49-37040
PLT 6: Japanese Patent Publication (A) No. 2-157196
PLT 7: Japanese Patent Publication (A) No. 4-214099 PLT 8: European Patent Application EP 0 962 963

### Non-Patent Literature

0013 NPLT 1: S. Nakamura et al., Jpn. J. Appl. Phys, Vol. 42, p. L846 (2003)
NPLT 2: Journal of Applied Physics, 102(4), pages 43523 - 43523
NPLT 3: Pedersen h et al., Journal of Crystal Growth 2008, 311(5), pages 1321 - 1327
NPLT 4: La Via et al., Chemical Vapour Deposition 2006, vol. 12, pages 509 - 515
NPLT 5: Zhang et al., Mat. Science Forum 2009, vol. 600-603, pages 103 - 106
NPLT 6: La Via et al., Mat. Science Forum 2009, vol. 600-603, pages 123 - 126
NPLT 7: Henry et al., Mat. Science Forum 2009, vol. 615-617, pages 81 - 84

### Summary of Invention

### Technical Problem

**0014** As explained above, in an SiC substrate with a small off angle obtained by the prior art, that is, an SiC substrate with a 6° or less off angle, it became clear that there was the problem that a high quality epitaxial film suppressing the occurrence of step bunching cannot be obtained and the device characteristics and the device yield are not sufficient.

**0015** Further, regarding the method for growing an epitaxial film on an SiC substrate, the methods such as described in the above PLTs are known.

**0016** However, PLTs 2 and 3 do not disclose to suppress the occurrence of step bunching at the time of growing a film on a 6° or less off angle SiC substrate by epitaxial growth. In fact, the inventors studied the conditions disclosed in these literature whereupon with a 6° or less off angle SiC substrate, a high quality epitaxial film suppressed in occurrence of step bunching could not be obtained and the device characteristics and the device yield were not sufficient. Further, similarly, they studied conditions similar to PLTs 5 to 7, whereupon with a low substrate temperature, 6° or less off angle SiC substrate, a high quality epitaxial film suppressed in occurrence of step bunching, that is, an epitaxial film having a smooth surface with a sub nanometer level or less surface roughness, could not be obtained and the device characteristics and the device yield were not sufficient.

**0017** The present invention has as its object the method of claim 1.

### Solution to Problem

**0018** The inventors discovered that it is possible to solve the above problem by adding hydrogen chloride gas into the material gases (source gases), which flow at the time of epitaxial growth, under specific conditions and thereby completed the invention. Further, using this method, the occurrence of step bunching is suppressed. As a result, it becomes possible to fabricate an epitaxial SiC monocrystalline substrate using an off angle 6° or less SiC substrate. The inventors used the epitaxial SiC monocrystalline substrate and studied the device characteristics and device yield in detail. With an epitaxial SiC monocrystalline substrate using an off angle 6° or less SiC substrate, silicon carbide monocrystalline thin film with a surface having a surface roughness (Ra value) of 0.5 nm or less could not be obtained, so the device characteristics and the device yield at that surface roughness level were not known, but the inventors conducted studies using epitaxial SiC monocrystalline substrates prepared by the above method and as a result discovered that if the silicon carbide monocrystalline thin film surface has a surface roughness (Ra value) of 0.5 nm or less, the device characteristics and the device yield are remarkably improved.

**0019** That is, the present invention has as its gist the following:
A method of production of an epitaxial silicon carbide monocrystalline substrate comprising epitaxially growing a silicon carbide monocrystalline thin film on a silicon carbide monocrystalline substrate with an off angle of 6° or less by a thermal chemical vapor deposition method during which feeding source gases which contain carbon and silicon and simultaneously feeding a hydrogen chloride gas and making a ratio of the number of chlorine atoms in the hydrogen chloride gas with respect to the number of silicon atoms in the source gases (Cl/Si ratio) from 4.0 to 10.0.

### Advantageous Effects of Invention

**0020** According to the present invention, it is possible to provide a SiC monocrystalline substrate which, even if the off angle of the substrate is 6° or less, suppresses the occurrence of step bunching and has a high quality epitaxial film with a small Ra value of surface roughness.

**0021** Further, the method of production of the present invention is a thermal CVD method, so is easy in hardware configuration and superior in controllability and gives an epitaxial film which is high in uniformity and reproducibility.

**0022** Furthermore, a device using the epitaxial SiC monocrystalline substrate of the present invention is formed on a high quality epitaxial film with a small surface roughness Ra value and superior smoothness, so is improved in characteristics and yield.

### Brief Description of Drawings

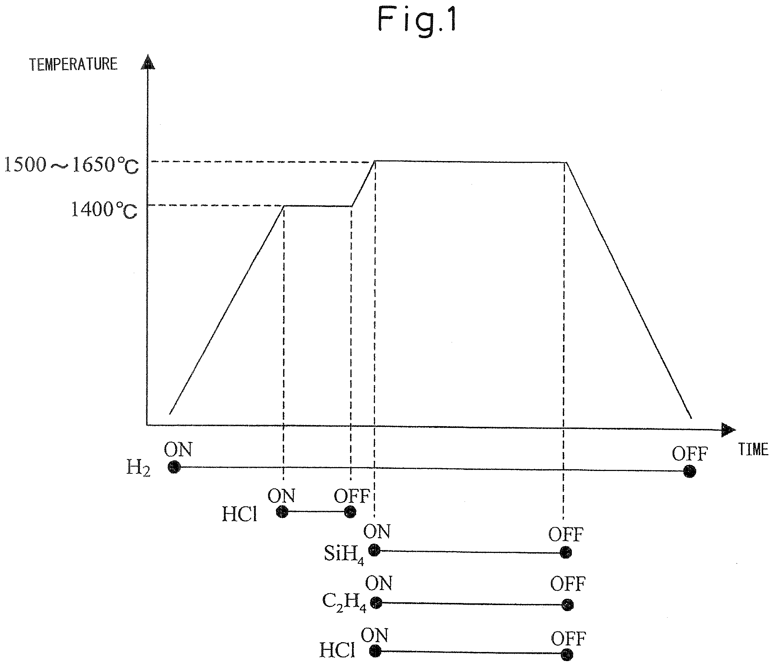

**0023** FIG. 1 shows a growth sequence of an SiC epitaxial film according to an example of the present invention.
FIG. 2 shows an optical micrograph of surface conditions of an SiC epitaxial film which is grown according to an example of the present invention.
FIG. 3 shows a surface AFM image of an SiC epitaxial film which is grown according to an example of the present invention.
FIG. 4 shows the forward direction characteristics of a Schottky barrier diode which is formed on an SiC epitaxial film grown according to an example of the present invention.
FIG. 5 shows an optical micrograph of surface conditions of an SiC epitaxial film which is grown according to another example of the present invention.
FIG. 6 shows a growth sequence of an SiC epitaxial film according to the related art.
FIG. 7 shows an optical micrograph of surface conditions of an SiC epitaxial film which is grown according to the related art.
FIG. 8 shows a surface AFM image of an SiC epitaxial film which is grown by the related art.

### Description of Embodiments

**0024** The specific content of the present invention will be explained below.
First, epitaxial growth on an SiC monocrystalline substrate will be explained.
The apparatus used for epitaxial growth in the present invention is a horizontal type thermal CVD apparatus. The thermal CVD method is simple in hardware configuration and enables control of growth by turning gases on/off, so is growth method which is superior in the controllability and reproducibility of an epitaxial film.

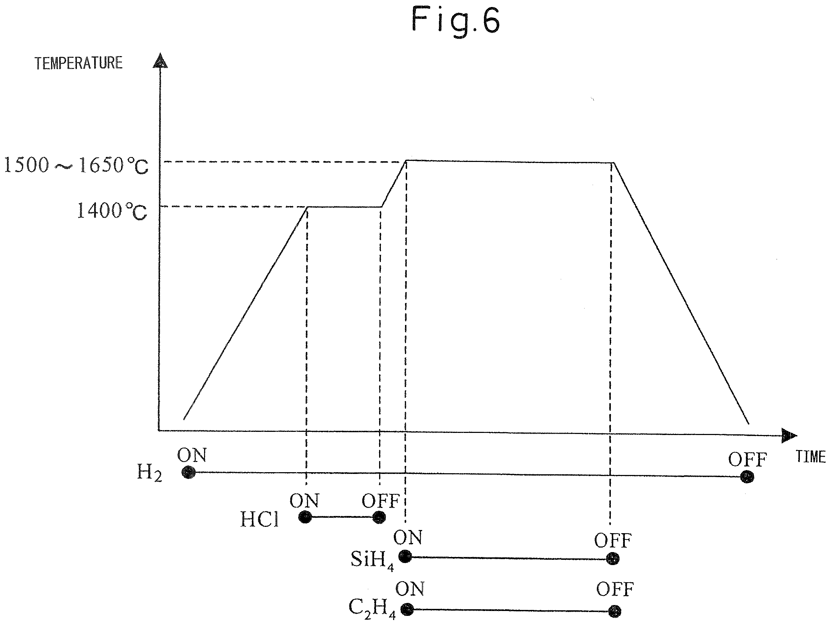

**0025** FIG. 6 shows a typical growth sequence at the time of conventional epitaxial film growth together with the timings of introduction of gases. First, a substrate is set in a growth furnace, the inside of the growth furnace is evacuated, then hydrogen gas is introduced and the pressure is adjusted to 1×10⁴ to 3×10⁴ Pa. After that, while holding the pressure constant, the temperature of the growth furnace is raised. Around about 1400°C, the substrate is etched for 10 to 30 minutes in hydrogen or in hydrogen chloride when introducing hydrogen chloride. This is for removing a degraded layer of the substrate surface resulting from polishing etc. and thereby exposing a clean surface. The etching step of the substrate is preferably performed for cleaning the substrate surface before growth of the silicon carbide monocrystalline film, but even without this step, the advantageous effects of the present invention are obtained. For example, if already a substrate having a clean surface, the etching step of the substrate is not required. After that, the temperature is raised to the growth temperature of 1500 to 1600°C or 1500 to 1650°C and the material gases (source gases) of SiH₄ and C₂H₄ are introduced to start the growth (that is, the thermal CVD method of growth at 1500°C or more). The SiH₄ flow rate is 40 to 50 cm³ per minute the C₂H₄ flow rate is 20 to 40 cm³ or 30 to 40 cm³ per minute, and the growth rate is 6 to 7 µm per hour. This growth rate is determined in consideration of the productivity since the usually used film thickness of an epitaxial layer is about 10 µm. At the point of time when grown for a certain time and a desired film thickness is obtained, the introduction of SiH₄ and C₂H₄ is stopped and the temperature is lowered in a state while feeding only hydrogen gas. After the temperature falls to ordinary temperature, the introduction of hydrogen gas is stopped, the inside of the growth chamber is evacuated, an inert gas is introduced into the growth chamber, the growth chamber is restored to atmospheric pressure, then the substrate is taken out.

**0026** Next, the content of the present invention will be explained by the growth sequence of FIG. 6. The procedure from setting the SiC monocrystalline substrate to the etching in the hydrogen or hydrogen chloride is similar to FIG. 6. After that, the temperature is raised to the growth temperature of 1500 to 1600°C or 1500 to 1650°C and the material gases of SiH₄ and C₂H₄ are fed to start the growth. At this time, the HCl gas is also simultaneously introduced. Preferably, the SiH₄ flow rate is 40 to 50 cm³ per minute, the C₂H₄ flow rate is 20 to 40 cm³ or 30 to 40 cm³ per minute, and the HCl flow rate is 40 to 1000 cm³ or so per minute so that the ratio of the numbers of atoms of Si and Cl in the gases (Cl/Si ratio) becomes 4.0 to 10.0. The growth rate is substantially the same as the case of not feeding an HCl gas. When the desired film thickness is obtained, the introduction of the SiH₄ and C₂H₄ and the HCl is stopped. The procedure after that is similar to the case of not feeding an HCl gas. In this way, by simultaneously feeding the source gases and the HCl gas, a good epitaxial film suppressed in occurrence of surface step bunching is obtained even on a substrate having a small off angle of 6° or less. **0027** This is believed to be due to the following. As one cause obstructing the step flow at the growth surface, it is believed that the Si atoms produced by the breakdown of SiH₄ bond in the vapor phase bond together and form nuclei for formation of Si droplets which deposit on the substrate. Alternatively, there is undeniably also the possibility of excessive Si atoms aggregating at the growth surface. In particular, as the off angle of the substrate becomes smaller and the width of the terrace becomes larger, the above phenomenon is believed to become more pronounced. This is believed to be because by introduction of the HCl gas, the HCl breaks down and produces Cl which takes the form of Si-Cl in the vapor phase and thereby suppresses the bonding of Si with itself, because excessive Si on the growth surface is reevaporated in the form of SiHₓCl_{y}, and because of other effects as a result of which step flow growth is sustained even on a substrate with a small off angle. **0028** On the other hand, as the method of use of HCl at the time of epitaxial growth on a small off angle SiC substrate, as explained above, there are the methods which are proposed in PLTs 2 and 3. However, in the case of the method of PLT 2, the object is the cleaning of the substrate surface so as to improve the quality of the epitaxial film (reduce the etch pit density). In this example, an 8° off angle substrate is used. This does not relate to prevention of the occurrence of step bunching at the time of epitaxial growth on a substrate having a 6° or less off angle. Further, the case of the method of PLT 3 also includes the case of epitaxial growth on a substrate having a 6° or less off angle, but as the effect of addition of HCl, the forcible formation of steps of the substrate surface by etching by HCl is mentioned. By increasing the steps, the formation of 3C-SiC on the surface is prevented. Therefore, this fundamentally differs from the present invention which utilizes the reaction between the Cl produced by the breakdown of HCl and the Si so as to make the surface roughness Ra 0.5 nm or less.

**0029** That is, the present invention introduces HCl gas along with the source gases during the epitaxial growth, but as explained above, the present invention does not utilize the etching action of HCl, but utilizes the action of forming Si-Cl in the vapor phase and suppressing bonding of Si with itself, so the growth rate of the epitaxial film is substantially similarly sufficient larger like with the case of not introducing HCl. Specifically, the condition is a small amount of introduction of HCl so that almost no etching action occurs (in terms of Cl/Si ratio, 1.0 to 20.0 in range). PLT 2 describes, as explained above, while relating to an SiC substrate with an off angle of 8°, the introduction of HCl during growth in the range, in terms of the Cl/Si ratio, of 10 to 100. However, this includes conditions of introducing a large amount of HCl so that the Cl/Si ratio exceeds 20 during growth, so the above advantageous effect of the present invention is not obtained. To obtain the advantageous effect of the present invention, it is important that the amount of HCl which is introduced during the growth not be a Cl/Si ratio of over 20.0.

**0030** According to the present invention, even on a substrate which has a small off angle of 6° or less (that is, a 0° to 6° off angle), a good epitaxial film on which occurrence of surface step bunching is suppressed is obtained, but the thickness of the grown epitaxial layer is preferably 5 µm to 50 µm if considering the withstand voltage of the usually formed device, the productivity of the epitaxial film, etc. Further, a substrate which has an off angle of over an off angle of 0° is preferable from the viewpoint of the ease of growth of an epitaxial film. Furthermore, regarding the off angle of the substrate, if 1° or less, the number of steps present on the surface become smaller and the advantageous effects of the present invention become difficult to obtain, so the angle is preferably greater than 1° and not more than 6°. Further, if the Cl/Si ratio in the gas at the time of growth is smaller than 1.0, the advantageous effect of addition of the HCl gas is not manifested, while if larger than 20.0, the HCl gas causes etching, so the ratio is from 4.0 to 10.0. The preferable Cl/Si ratio is 4.0 to less than 10.0.

**0031** Furthermore, the C/Si ratio in the material gas is preferably 1.5 or less so as to promote step flow growth, but if smaller than 1.0, due to the so-called site competition effect, the intake of residual oxygen becomes greater and the epitaxial film falls in purity, so more preferably this is between 1.0 to 1.5.

**0032** Further, in the present invention, in an Si substrate with an off angle of 6° or less, if a size of a diameter of 2 inches or more (diameter of 50 mm or more), the advantageous effect of the present invention becomes more pronounced. If the SiC substrate is small (for example, less than a diameter of 2 inches (diameter of 50 mm)), it is easy to heat the entire substrate surface by the heating of the substrate in the thermal CVD method. As a result, step bunching hardly occurs.

**0033** Accordingly, even if introducing HCl under the conditions of the present invention, sometimes it is not possible to obtain the effect of suppression of the occurrence of step bunching. However, even in small SiC substrates, if the heating method is uneven, step bunching more easily occurs, so the effect of the present invention is remarkably obtained. On the other hand, if the SiC substrate becomes larger and becomes a diameter of 2 inches (diameter of 50 mm) or more, uniformly heating the substrate surface as a whole (maintaining it at a uniform temperature) becomes difficult, so the speed of crystal growth will become different depending on the location and, as a result, step bunching will more easily occur. Therefore, in a large SiC substrate where such step bunching easily occurs, by introducing HCl under the conditions of the present invention, the effect of suppressing the occurrence of step bunching can be sufficiently manifested.

**0034** Further, according to the present invention, by ensuring the presence of a predetermined flow rate of HCl gas at the time of growing an epitaxial film on an SiC monocrystalline substrate, it is possible to obtain a high quality SiC monocrystalline thin film with a surface roughness (Ra value) of 0.5 nm or less. Further, the surface roughness Ra is the arithmetic mean roughness based on JIS B0601:2001. If using the more suitable conditions in the method of production of the present invention, it is possible to easily obtain a high quality SiC monocrystalline thin film with a surface roughness (Ra value) of 0.4 nm or less.

**0035** Furthermore, the inventors prepared SiC monocrystalline substrates having various epitaxial films differing in surface roughness, including a surface roughness (Ra value) of 0.5 nm or less, according to the present invention and investigated their device characteristics and device yields. As a result, as shown in the following examples as well, the inventors discovered that if the SiC monocrystalline thin film surface has a surface roughness (Ra value) of 0.5 nm or less, preferably 0.4 nm or less, the device characteristics and the device yield are remarkably improved.

**0036** The devices which are preferably formed on the thus grown epitaxial substrate are Schottky barrier diodes, PIN diodes, MOS diodes, MOS transistors, and other devices which are particularly used for controlling power.

### Examples

### 0037 (Example 1)

A 2 inch (50 mm) wafer-use SiC monocrystalline ingot was sliced into an approximately 400 µm thickness. This was coarsely ground and normally polished by a diamond abrasive to obtain an SiC monocrystalline substrate having a 4H polytype. A film was epitaxially grown on the Si surface of this. The off angle of the substrate was 4°. As the growth procedure, the substrate was set in a growth furnace, the inside of the growth furnace was evacuated, then hydrogen gas was introduced at a rate of 150 liters per minute while adjusting the pressure to 1.0×10⁴ Pa. After this, while holding the pressure constant, the temperature of the growth furnace was raised. After reaching 1550°C, hydrogen chloride was introduced at 1000 cm³ per minute and the substrate was etched for 20 minutes. After the etching, the temperature was raised to 1600°C, the SiH₄ flow rate was made 40 cm³ per minute, the C₂H₄ flow rate was made 22 cm³ per minute (C/Si=1.1), and the HCl flow rate was made 200 cm³ per minute (Cl/Si=5.0) to grow an epitaxial layer of 10 µm. The growth rate at this time was about 7 µm per hour.

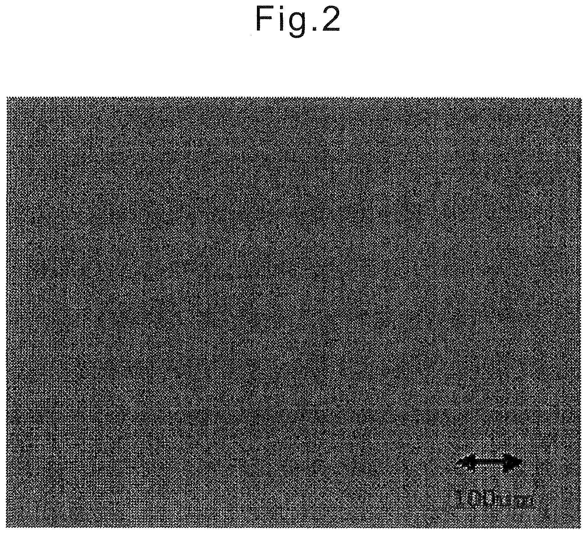

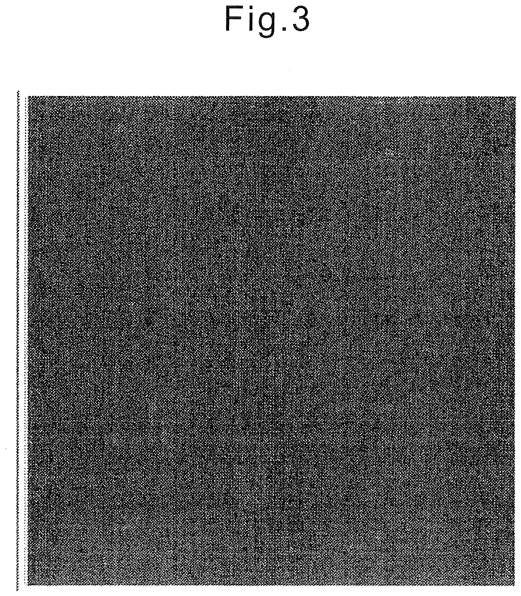

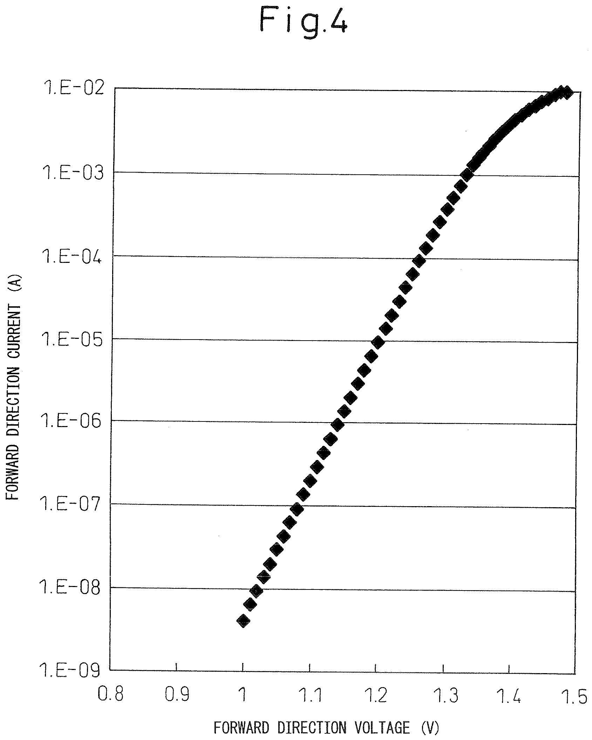

**0038** An optical micrograph of the surface of the film which is epitaxially grown in this way is shown in FIG. 3, while a surface AFM image is shown in FIG. 3. From FIG. 2, it will be understood that the surface becomes a mirror surface and no step bunching occurs. Further, from FIG. 3, it will be understood that the Ra value of the surface roughness is 0.21 nm. This is substantially equivalent to the value of a film epitaxially grown on an 8° off substrate. The forward direction characteristics of a diode when using such an epitaxial film to form a Schottky barrier diode (diameter 200 µm) are shown in FIG. 4. From FIG. 4, it is learned that the linearity at the time of the rising edge of the current is good and that the n-value showing the performance of the diode is 1.01, that is, substantially ideal characteristics are obtained. Further, in the same way as before, 100 Schottky barrier diodes were further fabricated on the same substrate and similarly evaluated, whereupon all were free of defects and exhibited similar characteristics.

### 0039 (Example 2)

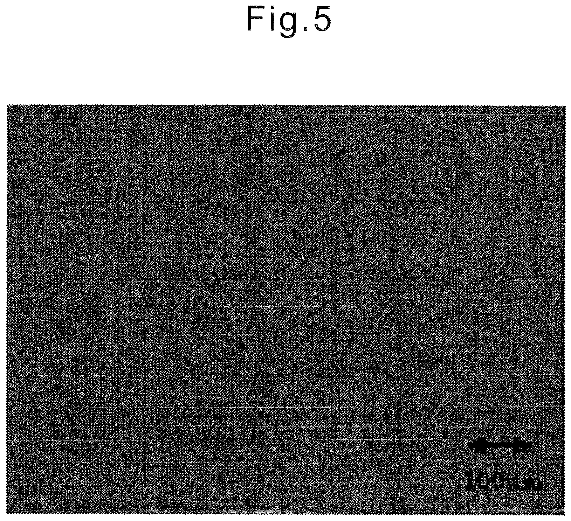

A film was epitaxially grown on an Si surface of a 2 inch (50 mm) SiC monocrystalline substrate having a 4H polytype obtained by slicing, coarse grinding, and ordinary polishing in the same way as Example 1. The off angle of the substrate was 4°. The growth procedure, temperature, etc. were similar to those in Example 1, while the gas flow rates were made an SiH₄ flow rate of 40 cm³ per minute, a C₂H₄ flow rate of 22 cm³ per minute (C/Si=1.1), and an HCl flow rate of 400 cm³ per minute (Cl/Si=10.0) so as to grow an epitaxial layer of 10 µm. An optical micrograph of the epitaxial film after growth is shown in FIG. 5. From FIG. 5, it is learned that even in the case of these conditions, the film is a good one with no step bunching occurring. Further, from AFM evaluation, the surface roughness Ra value was 0.16 nm. After growth, in the same way as in Example 1, Schottky barrier diodes were formed and evaluated for withstand voltage in the reverse direction together with Schottky barrier diodes which were formed on the epitaxial film on a 4° off substrate 4 by the conventional method not adding HCl during growth. The results of evaluation of 100 of each of these diodes showed that diodes on the epitaxial film according to the present invention had a withstand voltage (central value) of 340V, while diodes on the epitaxial film of the conventional method (surface roughness Ra value: 2.5 nm) had a withstand voltage (central value) of 320V, that is, diodes on the epitaxial film according to the present invention exhibited superior characteristics. The 100 diodes prepared on the epitaxial film according to the present invention were all free of defects. Among the 100 diodes prepared on the epitaxial film according to the conventional method, five were defective.

### 0040 (Example 3)

A film was epitaxially grown on an Si surface of a 2 inch (50 mm) SiC monocrystalline substrate having a 4H polytype obtained by slicing, coarse grinding, and ordinary polishing in the same way as Example 1. The off angle of the substrate was 4°. The growth procedure, temperature, etc. were similar to those in Example 1, while the gas flow rates were made an SiH₄ flow rate of 40 cm³ per minute, a C₂H₄ flow rate of 28 cm³ per minute (C/Si=1.4), and an HCl flow rate of 200 cm³ per minute (Cl/Si=5.0) to grow an epitaxial layer of 10 µm. After growth, the epitaxial film was a good film with no step bunching occurring and had a surface roughness Ra value of 0.23 nm. In the same way as Example 1, a Schottky barrier diode was formed. When finding the n-value, it was 1.01. In this case as well, it was learned that substantially ideal characteristics were obtained. Further, in the same way as before, a further 100 Schottky barrier diodes were formed on the same substrate and evaluated in the same way, whereupon all were free of defects and exhibited similar characteristics.

### 0041 (Example 4)

A film was epitaxially grown on an Si surface of a 2 inch (50 mm) SiC monocrystalline substrate having a 4H polytype obtained by slicing, coarse grinding, and ordinary polishing in the same way as Example 1. The off angle of the substrate was 2°. The growth procedure, temperature, etc. were similar to those in Example 1, while the gas flow rates were made an SiH₄ flow rate of 40 cm³ per minute, a C₂H₄ flow rate of 20 cm³ per minute (C/Si=1.0), and an HCl flow rate of 400 cm³ (Cl/Si=10.0) per minute to grow an epitaxial layer of 10 µm. After growth, the epitaxial film was a good film with no step bunching occurring and had a surface roughness Ra value of 0.26 nm. A Schottky barrier diode formed in the same way as Example 1 had an n-value of 1.02. In this case as well, it was learned that substantially ideal characteristics were obtained. Further, in the same way as before, a further 100 Schottky barrier diodes were formed on the same substrate and evaluated in the same way, whereupon all were free of defects and exhibited similar characteristics.

### 0042 (Example 5)

A film was epitaxially grown on an Si surface of a 2 inch (50 mm) SiC monocrystalline substrate having a 4H polytype obtained by slicing, coarse grinding, and ordinary polishing in the same way as Example 1. The off angle of the substrate was 6°. The growth procedure, temperature, etc. were similar to those in Example 1, while the gas flow rates were made an SiH₄ flow rate of 40 cm³ per minute, a C₂H₄ flow rate of 22 cm³ per minute (C/Si=1.1), and an HCl flow rate of 200 cm³ per minute (Cl/Si=5.0) to grow an epitaxial layer of 10 µm. After growth, the epitaxial film was a good film with no step bunching occurring and had a surface roughness Ra value of 0.19 nm. This epitaxial film and an epitaxial film on a 6° off substrate formed by a conventional method were used in the same way as in Example 2 to evaluate the reverse direction withstand voltage for 50 Schottky barrier diodes. The results showed that diodes on the epitaxial film according to the present invention had a withstand voltage (central value) of 350V, while diodes on the epitaxial film of the conventional method (surface roughness Ra value: 2 nm) had a withstand voltage (central value) of 330V, that is, diodes on the epitaxial film according to the present invention exhibited superior characteristics. The 100 diodes prepared on the epitaxial film according to the present invention were all free of defects. Among the 100 diodes prepared on the epitaxial film according to the conventional method, five were defective.

### 0043 (Examples 6 to 17)

Films were epitaxially grown on Si surfaces of 2 inch (50 mm) SiC monocrystalline substrates having a 4H polytype obtained by slicing, coarse grinding, and ordinary polishing in the same way as Example 1. The growth procedures, temperatures, etc. were similar to those in Example 1, while the off angles of the substrates, C/Si ratios, and Cl/Si ratios were changed as in Table 1 to grow epitaxial layers of 10 µm. After growth, the epitaxial films were good films with no occurrence of step bunching. Table 1 also shows the surface roughness Ra values of the epitaxial films after growth and the n-values of Schottky barrier diodes formed in the same way as Example 1. The Ra values were all 0.4 nm or less, that is, films with good smoothnesses were obtained, further, the n-values were 1.03 or less, that is, substantially ideal diode characteristics were obtained. Note that, in Examples 1 to 17, the substrates were etched by hydrogen chloride before growth, but even if omitting this process, no change was seen in the Ra value after growth. Further, Example 6 has an Ra value of 0.4 nm and an n-value of 1.03. It has no off angle of the substrate, so the crystal growth rate was slow and it took a long time to form a thickness of 10 µm compared with the case of using a substrate with an off angle.

0044

**Table 1**

| | Off angle of substrate (°) | C/Si ratio | Cl/Si ratio | Ra (nm) | n-value |
|---|---|---|---|---|---|
| Example 6 | 0 | 1.0 | 4.0 | 0.50 | 1.03 |
| Example 7 | 1 | 1.0 | 4.0 | 0.40 | 1.03 |
| Example 8 | 1.2 | 1.0 | 4.0 | 0.39 | 1.03 |
| Example 9 | 2 | 0.5 | 1.0 | 0.38 | 1.02 |
| Example 10 | | | 4.0 | 0.34 | 1.02 |
| Example 11 | | | 9.0 | 0.34 | 1.02 |
| Example 12 | | | 10.0 | 0.34 | 1.02 |
| Example 13 | | | 20.0 | 0.35 | 1.02 |
| Example 4 | | 1.0 | 1.0 | 0.26 | 1.02 |
| Example 14 | | | 4.0 | 0.25 | 1.02 |
| Example 15 | | | 9.0 | 0.25 | 1.02 |
| Example 16 | | | 10.0 | 0.26 | 1.02 |
| Example 17 | | | 20.0 | 0.30 | 1.03 |
| Example 18 | | 1.5 | 1.0 | 0.4 | 1.03 |
| Example 19 | | | 4.0 | 0.32 | 1.03 |
| Example 20 | | | 9.0 | 0.32 | 1.03 |
| Example 21 | | | 10.0 | 0.35 | 1.03 |
| Example 22 | | | 20.0 | 0.38 | 1.03 |
| Example 23 | | 1.6 | 4.0 | 0.40 | 1.03 |
| Example 24 | 4 | 0.5 | 1.0 | 0.22 | 1.01 |
| Example 25 | | | 4.0 | 0.21 | 1.01 |
| Example 26 | | | 9.0 | 0.21 | 1.01 |
| Example 27 | | | 10.0 | 0.22 | 1.01 |
| Example 28 | | | 20 | 0.24 | 1.01 |
| Example 29 | | 0.9 | 4.0 | 0.21 | 1.01 |
| Example 30 | | 1.0 | 1.0 | 0.21 | 1.01 |
| Example 31 | | | 4.0 | 0.18 | 1.01 |
| Example 32 | | | 9.0 | 0.17 | 1.01 |
| Example 33 | | | 10.0 | 0.20 | 1.01 |
| Example 34 | | | 20.0 | 0.24 | 1.02 |
| Example 1 | | 1.1 | 5.0 | 0.21 | 1.01 |
| Example 2 | | | 10.0 | 0.16 | 1.01 |
| Example 3 | | 1.4 | 5.0 | 0.23 | 1.01 |
| Example 35 | | 1.5 | 1 | 0.28 | 1.02 |
| Example 36 | | | 20 | 0.29 | 1.03 |
| Example 37 | | 1.6 | 5.0 | 0.30 | 1.03 |
| Example 38 | 6 | 0.5 | 1.0 | 0.21 | 1.01 |
| Example 39 | | | 4.0 | 0.18 | 1.01 |
| Example 40 | | | | | 1.01 |
| | | | | 0.18 | |
| | | | 9.0 | | |
| Example 41 | | | 10.0 | 0.22 | 1.01 |
| | | | | | |
| Example 42 | | | 20 | 0.24 | 1.01 |
| Example 43 | | 0.9 | 4.0 | 0.20 | 1.01 |
| Example 44 | | 1.0 | 1.0 | 0.20 | 1.01 |
| Example 45 | | | 4.0 | 0.18 | 1.01 |
| Example 46 | | | 9.0 | 0.18 | 1.01 |
| Example 47 | | | 10.0 | 0.20 | 1.01 |
| Example 48 | | | 20.0 | 0.22 | 1.01 |
| Comp. Ex. 49 | | 1.1 | 0 | 1.9 | 1.20 |
| Example 5 | | | 5.0 | 0.19 | 1.01 |
| Example 50 | | 1.5 | 1.0 | 0.25 | 1.02 |
| Example 51 | | | 4.0 | 0.22 | 1.02 |
| Example 52 | | | 9.0 | 0.22 | 1.02 |
| Example 53 | | | 10.0 | 0.24 | 1.02 |
| Example 54 | | | 20.0 | 0.26 | 1.02 |

### 0045 (Comparative Example)

Examples 4,9, 13, 17, 18, 22, 24, 28, 34, 35, 36, 42, 44, 49, 50, 54 fall outside the scope of the invention.

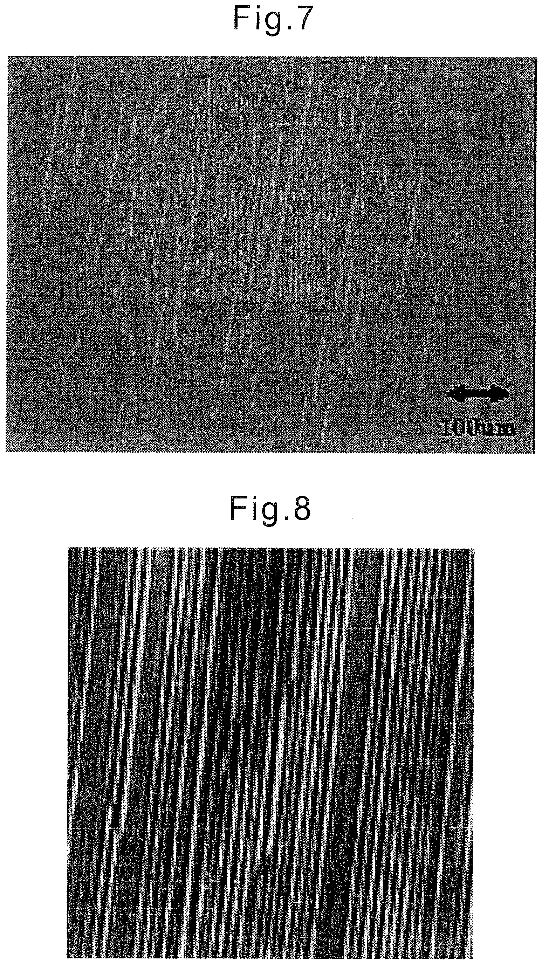

As a comparative example, a film was epitaxially grown on an Si surface of a 2 inch (50 mm) SiC monocrystalline substrate having a 4H polytype obtained by slicing, coarse grinding, and ordinary polishing in the same way as Example 1. The off angle of the substrate was 6°. The growth procedure, temperature, etc. are similar to Example 1, but the gas flow rates were made an SiH₄ flow rate of 40 cm³ per minute and a C₂H₄ flow rate of 22 cm³ per minute (C/Si=1.1) and no feed of HC1 to grow an epitaxial layer of 10 µm. An optical micrograph of the epitaxial film after growth is shown in FIG. 7, while a surface AFM image is shown in FIG. 8. From FIG. 7 and FIG. 8, it will be understood that the surface after growth becomes wrinkled and step bunching occurs. Further, from FIG. 8, the surface roughness Ra value was 1.9 nm - compared with Examples 1 to 5, approximately one order of magnitude larger. As shown in the case of Example 5, a Schottky barrier diode was formed on such an epitaxial film and evaluated for reverse direction withstand voltage, whereupon, compared with a diode on an epitaxial film according to the present invention, the characteristics were inferior. Similarly, the inventors prepared 100 Schottky barrier diodes. Defects occurred in eight among them.

**0046** Further, SiC monocrystalline substrates with an off angle of the substrate of 7° were prepared in the same way as in Example 1. Epitaxial films were grown in the same way as in Example 1 for the case of feeding HCl at the same time as the source gases and the case of not feeding HCl. Since the off angle was large, step bunching inherently did not occur, so even if not adding HCl, the growth surface was smooth, while if adding HCl, the growth surface had the same smoothness.

**0047** Further, the temperature at the time of crystal growth in Example 1 was 1600°C, but the inventors similarly grew crystals at 1500°C and 1650°C, whereupon they obtained the same results. The inventors grew crystals at 1450°C in the same way as Example 1, but when preparing Schottky barrier diodes, the defect rate became greater. Further, the inventors grew crystals at 1700°C in the same way as in Example 1, but only results with a surface roughness Ra value of over 0.4 could be obtained. Therefore, the temperature range at the time of crystal growth should preferably be made 1500 to 1650°C.

### Industrial Applicability

**0048** According to this invention, in epitaxial growth on an SiC monocrystalline substrate, it is possible to prepare an epitaxial SiC monocrystalline substrate having a high quality epitaxial film with little step bunching. For this reason, if forming electronic devices on such a substrate, the device characteristics and yield can be expected to be improved. In the examples, as the material gas, SiH₄ and C₂H₄ were used, but even if using trichlorosilane as the Si source and using C₃H₈ etc. as the C source, the result is the same.

## Claims

1. A method of production of an epitaxial silicon carbide monocrystalline substrate comprising epitaxially growing a silicon carbide monocrystalline thin film on a silicon carbide monocrystalline substrate with an off angle of 6° or less by a thermal chemical vapor deposition method during which feeding source gases which contain carbon and silicon and simultaneously feeding a hydrogen chloride gas, **characterized in that** a ratio of the number of chlorine atoms in the hydrogen chloride gas with respect to the number of silicon atoms in the source gases (Cl/Si ratio) is from 4.0 to 10.0.

## Patentansprüche

1. Ein Verfahren zur Herstellung eines epitaktischen monokristallinen Siliciumcarbid-Substrats, umfassend das epitaktische Aufwachsen eines monokristallinen Siliziumcarbid-Dünnfilms auf einem monokristallinen Siliciumcarbid-Substrat mit einem Versetzungswinkel von 6° oder weniger durch ein thermisch-chemisches Dampfabscheidungsverfahren, bei welchem Ausgangsgase, die Kohlenstoff und Silizium enthalten, zugeführt und gleichzeitig ein Chlorwasserstoffgas zugeführt wird, **dadurch gekennzeichnet, dass** ein Verhältnis der Anzahl der Chloratome im Chlorwasserstoffgas zur Anzahl der Siliziumatome in den Ausgangsgasen (Cl/Si-Verhältnis) von 4,0 bis 10,0 beträgt.

## Revendications

1. Procédé de production d'un substrat monocristallin de carbure de silicium épitaxial comprenant la croissance épitaxiale d'un mince film monocristallin de carbure de silicium sur un substrat monocristallin de carbure de silicium avec un angle décalé de 6° ou inférieur par un procédé de dépôt en phase vapeur chimique thermique pendant lequel on introduit des gaz source qui contiennent du carbone et du silicium et on introduit simultanément un gaz de chlorure d'hydrogène, **caractérisé en ce qu'**un rapport du nombre d'atomes de chlore dans le gaz de chlorure d'hydrogène par rapport au nombre d'atomes de silicium dans les gaz source (rapport Cl/Si) est de 4,0 à 10,0.
